# EUROPÄISCHE PATENTSCHRIFT

(11) **EP 0 542 057 B1**
(45) Veröffentlichungstag und Bekanntmachung des Hinweises auf die Patenterteilung: **12.07.1995**
(21) Anmeldenummer: 92118585.6
(22) Anmeldetag: 30.10.1992
(51) Int. Cl.: H02K 5/22, H02K 11/00, H02K 5/00, H01H 1/58, A47J 19/02

(54) **Träger für einen elektrischen Motor einer Küchenmaschine, insbesondere Zitruspresse**
Support for the electric motor of a kitchen machine, in particular lemon squeezer
Support pour le moteur électrique d'une machine de cuisine, en particulier presse-citrons

(30) Priorität: 11.11.1991 DE 4136924
(43) Veröffentlichungstag der Anmeldung: 19.05.1993
(73) Patentinhaber: Braun Aktiengesellschaft, Frankfurt am Main (DE)
(72) Erfinder: Burger, Diethard, W-6222 Geisenheim 2 (DE); Rebordosa Rius, Antonio, W-6370 Oberursel (DE); Penaranda Sanjuan, Mariano, E-08024 Barcelona (ES)

(56) Entgegenhaltungen:
- EP-A- 0 025 938
- EP-A- 0 411 331
- FR-A- 1 583 878
- GB-A- 2 137 430

## Beschreibung

Die Erfindung betrifft einen Träger für einen elektrischen Motor einer Küchenmaschine, insbesondere Zitruspresse, der eine Platine aus isolierendem Material mit einer Aufnahme zur Befestigung des Motors aufweist, auf der Endabschnitte ausgebildet sind, die über Anschlußkabel mit einer elektrischen Energiequelle verbindbar sind und die zum Verbinden von am Motor ausgebildeten Kontaktfahnen oder Kontaktstiften dienen, wobei die Kontaktstifte an die Endabschnitte in Form von Berührungskontakten angeschlossen sind.

Bei Maschinen oder Geräten, die mit einem elektrischen Antrieb versehen sind, ist es zweckmäßig, den Motor auf einem Träger anzuordnen, an dem weitere Bauelemente wie Schalteinrichtungen, elektrische Anschlüsse und Getriebeteile angebracht sind, um dadurch eine vormontierbare Baueinheit zu erhalten, durch die die Montage in der Maschine oder im Gerät erleichtert wird.

So ist es beispielsweise aus der GB-2 002 182 A bekannt, auf einem Träger einen Elektromotor mittels eines Bajonettverschlusses zu befestigen und dabei gleichzeitig die Motoranschlüsse mit an Anschlußkabeln befestigten Endabschnitten ohne zusätzliche Verbindungselemente zu kontaktieren. Diese Maßnahme erfordert zusätzlich zur axialen Verschiebung noch eine Drehbewegung des Elektromotors gegenüber dem Träger, so daß sich insbesondere bei der automatischen Montage derartiger Antriebseinheiten ein erhöhter Montageaufwand und somit zusätzliche Kosten ergeben.

Weiterhin ist in der DE-38 27 470 A1 ein aus Leiterbahnen bestehender elektrischer Geber (Mehrstufenschalter) beschrieben, der bei dessen Betätigung verschiedene Stromwege steuert.

Aufgabe der Erfindung ist es, einen Träger für einen elektrischen Antriebsmotor zu schaffen, der auf eine kostengünstig herstellbare und einfach zu montierende Weise eine Verbindung des Motors mit einem Anschlußkabel, einem Schalter oder weiteren elektrischen Bauelementen ermöglicht.

Diese Aufgabe wird erfindungsgemäß dadurch gelöst, daß die Endabschnitte an Leiterbahnen ausgebildet sind, daß die Leiterbahnen aus Blech ausgestanzt sind, daß die Endabschnitte derart elastisch verformbar ausgebildet sind, daß die Kontaktstifte des Motors bei dessen Verschiebung in Längsrichtung der Motorachse an die Endabschnitte federelastisch andrückbar sind und daß zur Bildung eines Schalters an die Leiterbahnen einander benachbarte Kontaktfahnen angeformt sind, von denen eine der Kontaktfahnen unter elastischer Verformung mit Hilfe eines bewegbaren Betätigungselements an die andere Kontaktfahne andrückbar ist. Hierdurch werden beim Befestigen des Motors auf dem Träger die Motoranschlüsse elektrisch leitend mit den Leiterbahnen verbunden, ohne daß es zusätzlicher Maßnahmen bedarf. Die Motormontage wird dadurch wesentlich vereinfacht.

Durch die Integration der Endabschnitte in Leiterbahnen und den im Motorgehäuse von Leiterbahnen gebildeten mechanisch betätigbaren Schalter wird nämlich die Montage des Motors am Träger sowie die Anordnung des gleichzeitig von den Leiterbahnen gebildeten Schalters besonders einfach und kostengünstig, so daß insbesondere bei derartigen Trägern, die in großen Stückzahlen in Haushaltsgeräten, insbesondere in Zitruspressen, eingesetzt werden, erhebliche Kosteneinsparungen erreicht werden können.

Der Schalter nach der Erfindung steht in Wirkverbindung mit einer im Träger integrierten Schalt- und Antriebseinheit, dessen Leiterbahnen einerseits zum Ein- bzw. Ausschalten der Antriebseinheit und andererseits zum Kontaktieren der Antriebseinheit dienen.

Zur Erzielung der erforderlichen Elastizität können die Endabschnitte der Leiterbahnen U-förmig abgebogen sein. Weiterhin kann vorgesehen sein, daß die elastisch verformbaren Endabschnitte in eine schlitzförmige Öffnung in der Platine ragen, wobei die Kontaktfahnen oder Kontaktstifte der Motoranschlüsse auf der den Leiterbahnen abgekehrten Seite der Platine angeordnet sind. Diese Ausgestaltung hat den Vorteil, daß der Motor und die Leiterbahnen auf entgegengesetzten Seiten der Platine angeordnet sein können und daher gleichzeitig oder in beliebiger Reihenfolge auf die Platine montiert werden können.

Eine weitere vorteilhafte Ausgestaltung der Erfindung kann darin bestehen, daß die Leiterbahnen als einteiliges Blechelement durch formschlüssige Mittel mit der Platine verbindbar sind und daß die Platine Öffnungen oder Aussparungen aufweist, durch die hindurch das Blechelement nach seiner Montage mittels eines Trennwerkzeugs in die einzelnen, voneinander getrennte Strompfade bildende Leiterbahnen zerteilbar ist. Mit der Weiterbildung der Erfindung wird ein Träger geschaffen, der aus einzelnen, getrennt voneinander herstellbaren Bauelementen ohne großen Montageaufwand zusammengesetzt werden kann. Die Platine kann ohne Einbeziehung der Leiterbahnen als Kunststoffspritzteil nach den hierbei zu berücksichtigenden Anforderungen hergestellt werden, und das Blechelement kann zur Bildung der Leiterbahnen entsprechend den Anforderungen der Blechformtechnik gestaltet sein. Da die Leiterbahnen vor der Montage in einem einzigen Bauteil, dem Blechelement, vereinigt sind, ist ihre Montage auf der Platine sehr einfach und auch mit Hilfe eines Montageautomaten möglich.

Zur Befestigung der Leiterbahnen auf der Platine kann nach einer weiteren Ausgestaltung der Erfindung vorgesehen sein, daß die Leiterbahnen elastisch verformbare Abschnitte aufweisen, die jeweils zwischen paarweise einander zugekehrte Haken einrastbar sind. Hierdurch wird mit einfachen Mitteln eine Schnappverbindung geschaffen, die keine zusätzlichen Befestigungsmittel erfordert und eine automatische Montage der Leiterbahnen ermöglicht. Zur Lagesicherung der Leiterbahnen können zusätzlich auf der Platine Vorsprünge vorgesehen sein, zwischen denen die Leiterbahnen verlaufen.

Vorzugsweise sind die Kontaktfahnen aus der Grundebene des Blechelements durch rechtwinkliges Abkanten derart herausgebogen, daß sie hochkant auf der Grundebene stehen und sich parallel zu dieser erstrecken. Zur seitlichen Abstützung der Kontaktfahnen sind auf der Platine vorzugsweise Stützrippen vorgesehen.

Um an der Platine auf einfache Weise das Anschlußkabel befestigen zu können, kann nach einer weiteren Ausgestaltung der Erfindung die Platine an einer Seite mehrere, hinterschnittene Schlitze aufweisen, in die das Anschlußkabel in Form mäanderförmiger Windungen einknöpfbar ist. Zusätzlich kann die Platine an die Schlitze angrenzende Wandelemente aufweisen, die die mäanderförmigen Windungen des Anschlußkabels teilweise umhüllen.

Die Erfindung wird nachfolgend anhand eines Ausführungsbeispiels näher erläutert, das in der Zeichnung dargestellt ist. Es zeigen
- Fig. 1: eine Draufsicht auf die mit Leiterbahnen bestückte Seite des erfindungsgemäßen Trägers,
- Fig. 2: einen Querschnitt durch den Träger gemäß Figur 1 entlang der Linie II-II und
- Fig. 3: einen Teilschnitt durch den Träger gemäß Figur 1 entlang der Linie III-III.

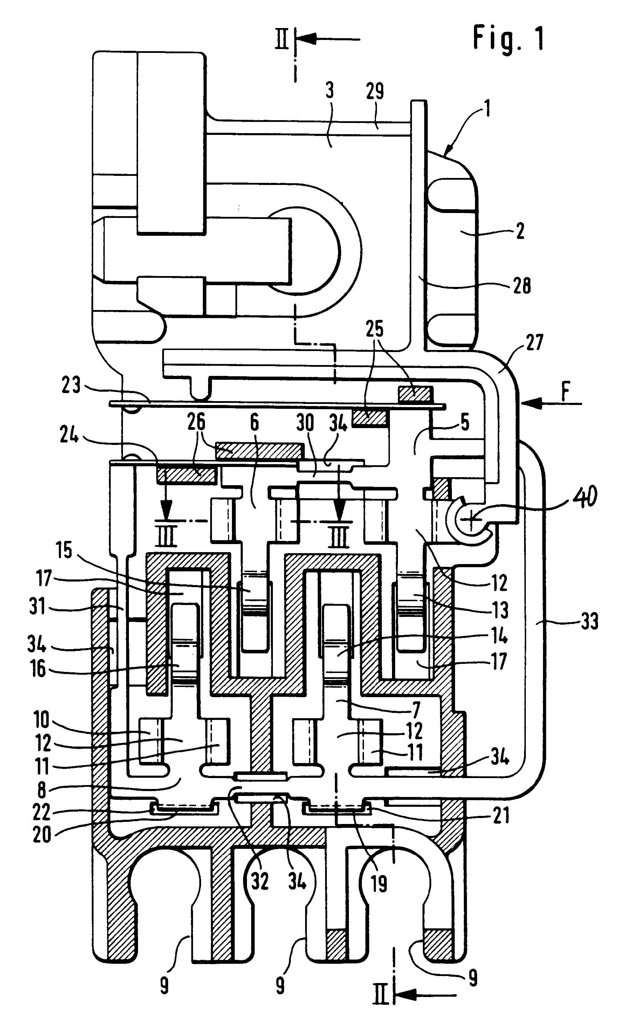

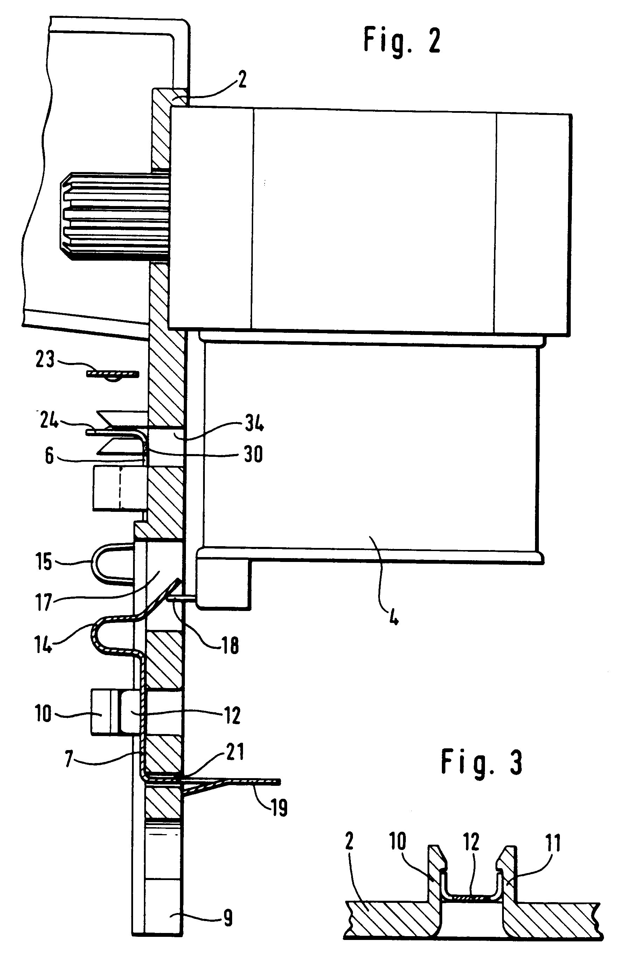

Der dargestellte Träger 1 besteht nach den Figuren 1 und 2 aus einer Platine 2 von im wesentlichen ebener Grundform, die aus einem isolierenden Kunststoff hergestellt ist. Auf der Platine 2 sind neben einer Aufnahme 3 zur Befestigung eines elektrischen Motors 4 mehrere Leiterbahnen 5, 6, 7, 8 aus dünnwandigem Kupferblech befestigt. An ihrem der Aufnahme 3 entgegengesetzten Ende weist die Platine 2 drei hinterschnittene Schlitze 9 auf, in die ein elektrisches Anschlußkabel eingeknöpft werden kann, dessen Leiter an die Leiterbahnen 7, 8 anschließbar sind.

Die Leiterbahnen 5 bis 8 werden nach Fig. 3 auf der Platine 2 jeweils von paarweise einander zugekehrten Haken 10, 11 gehalten, die von der Platinenoberfläche hochragen und mit ihren Zähnen jeweils den Schenkel eines U-förmig gebogenen Abschnitts 12 der Leiterbahnen 5 bis 8 übergreifen. Diese formschlüssige Befestigung der Leiterbahnen 5 bis 8 gewährleistet einen sicheren Halt und ist leicht montierbar, da sich die beiden Schenkel der U-förmigen Abschnitte 12 durch elastische Verformung soweit zusammendrücken lassen, daß die Abschnitte 12 zwischen den Zähnen der Haken 10, 11 hindurchgedrückt und unter die Haken 10, 11 gerastet werden können.

Die Leiterbahnen 5 bis 8 sind nach Fig. 1 im wesentlichen parallel zueinander und zur Längsachse der Platine 2 ausgerichtet und die Leiterbahnen 5, 6 sind in Längsrichtung der Platine 2 gegenüber den Leiterbahnen 7, 8 soweit versetzt, daß die den Schlitzen 9 zugekehrten Endabschnitte 13, 14 der Leiterbahnen 5, 6 und die der Aufnahme 3 zugekehrten Endabschnitte 15, 16 der Leiterbahnen 7, 8 nebeneinander liegen. Im Bereich der Endabschnitte 13 bis 16 weist die Platine 2 nach den Figuren 1 und 2 nebeneinander liegende, schlitzförmige Öffnungen 17 auf. Die Endabschnitte 13 bis 16 sind durch mehrfaches Umbiegen quer zu ihrer Längsachse zu elastisch verformbaren, U-förmigen Schleifen geformt und bilden mit ihren freien Schenkelenden in die Öffnungen 17 hineingreifende Berührungskontakte, die mit Vorspannung auf von der entgegengesetzten Seite der Platine 2 in die Öffnungen 17 hineinragenden Kontaktstiften 18 aufliegen. Die Kontaktstifte 18 sind an dem Motor 4 befestigt und jeweils mit den Anschlüssen der Motorwicklungen verbunden.

Die den Endabschnitten 15, 16 entgegengesetzten Enden 19, 20 der Leiterbahnen 7,8 sind nach Fig. 2 quer zu ihrer Längsachse rechtwinklig abgebogen und durch Schlitze 21, 22 in der Platine 2 hindurch gesteckt. Auf der Unterseite der Platine 2 sind die Enden 19, 20 als Kontaktfahnen ausgebildet, auf die jeweils ein an einem Leiter des Anschlußkabels angeschlossener Stecker (nicht dargestellt) aufsteckbar ist. Das Anschlußkabel selbst kann dann zur Stromversorgung in eine Steckdose (nicht dargestellt) einer elektrischen Versorgungsleitung eingesteckt werden.

Die den Endabschnitten 13, 14 entgegengesetzten Enden der Leiterbahnen 5, 6 sind nach Fig. 2 als Kontaktfahnen 23, 24 ausgebildet. Die Kontaktfahnen 23, 24 sind parallel nebeneinander und rechtwinklig zu den Leiterbahnen 5, 6 angeordnet und durch rechtwinkliges Abkanten an den Anschlußstellen der Leiterbahnen 5, 6 hochgestellt, so daß sie hochkant zur Oberfläche der Platine 2 ausgerichtet sind. Die Kontaktfahne 23 ist an der Anschlußstelle der Leiterbahn 5 durch Stützrippen 25 an der Platine 2 gehalten. Das freie Ende der Kontaktfahne 23 ist parallel zur Oberfläche der Platine 2 durch elastische Verformung bis zur Anlage an der Kontaktfahne 24 bewegbar. Die Kontaktfahne 24 ist nahezu auf ihrer gesamten Länge mit Hilfe von Stützrippen 26 an der Platine 2 abgestützt und daher unbeweglich. Die beiden Kontaktfahnen 23, 24 bilden einen Schalter, durch den die an die Leiterbahnen 5, 6 angeschlossenen Anschlüsse des Motors 4 miteinander verbunden werden können.

Zum Schließen des Schalters 23, 24 ist ein Betätigungselement 27 vorgesehen, das an der Platine 2 um den Drehpunkt 40 schwenkbar gelagert ist und durch Einwirkung einer Kraft F soweit geschwenkt werden kann, bis die Kontaktfahne 23 mit ihrem Ende das Ende der Kontaktfahne 24 berührt. Das Betätigungselement 27 weist einen einteilig mit diesem aus Kunststoff gespritzten Federarm 28 auf, der mit seinem Ende auf einer Rippe 29 der Platine 2 aufliegt und das Betätigungselement 27 in der in Figur 1 gezeigten Offenstellung des Schalters hält. Die zum Schließen des Schalters erforderliche Kraft F wird dabei in erster Linie durch die Federkraft des Federarms 28 bestimmt.

Die Leiterbahnen 5 bis 8 sind nach Fig. 1 zur Vereinfachung ihrer Montage untereinander durch Stege 30, 31, 32, sowie einen Bügel 33 miteinander verbunden. Sie bilden auf diese Weise zunächst ein einteiliges Blechelement, welches in mehreren Schritten durch Ausstanzen und Verformen aus einem ebenen Blech hergestellt ist. Ein solches einteiliges Blechelement läßt sich wesentlich leichter handhaben und montieren als einzelne, separate Leiterbahnen. So kann das Blechelement aufgrund der beschriebenen Ausgestaltung der Haken 10, 11 und der Abschnitte 12 (Fig. 3) von oben auf die Platine 2 aufgelegt und durch Andrücken fest mit der Platine 2 verbunden werden. Nach diesem Montagevorgang ist der Träger 1 jedoch noch nicht brauchbar, da die durch die einzelnen Leiterbahnen 5 bis 8 gebildeten Strompfade, wie sie in Fig. 1 dargestellt sind, noch nicht voneinander getrennt sind.

Um den Trennungsvorgang zu ermöglichen, sind In der Platine 2 im Bereich der Stege 30, 31, 32 und des Bügels 33 rechteckige Öffnungen 34 vorgesehen, durch die ein Schneidwerkzeug, beispielsweise ein Schneidstempel, von der Unterseite der Platine 2 her bis an die Stege 30 bis 32 und den Bügel 33 heranführbar ist (nicht dargestellt). In Verbindung mit einem von oben auf die Stege 30 bis 32 und den Bügel 33 aufsetzbaren Gegenwerkzeug lassen sich auf einfache Weise durch Heraustrennen der die Öffnungen 34 überspannenden Abschnitte der Stege 30 bis 32 und durch vollständiges Abtrennen des Bügels 33 die Leiterbahnen 5 bis 8 in voneinander separate Einzelelemente zerteilen, so daß sie jeweils einen isolierten Strompfad bilden können (nicht dargestellt).

Der Bügel 33 ist zur Bildung des einteiligen Blechelements nicht unbedingt erforderlich. Er sorgt jedoch für eine größere Stabilität und eine bessere Handhabbarkeit des Blechelements bei der Montage. Das Betätigungselement 27 wird nach dem Trennen der Leiterbahnen 5 bis 8 durch Einknöpfen seines Lagerzapfens in die Lagerbohrung der Platine 2 montiert.

Der beschriebene Träger eignet sich vor allem für kleine Elektromotoren, wie sie beispielsweise in Küchenmaschinen Anwendung finden. Besonders vorteilhaft ist die Anwendung zum Antrieb einer Zitruspresse. Hierbei kann über den axial beweglichen Preßkegel das Betätigungselement 27 bewegt und dadurch der Motor 4 über die sich nun berührenden Kontaktfahnen 23, 24 eingeschaltet werden.

## Patentansprüche

1. Träger für einen elektrischen Motor einer Küchenmaschine, insbesondere Zitruspresse, der eine Platine aus isolierendem Material mit einer Aufnahme zur Befestigung des Motors (4) aufweist, auf der Endabschnitte (13 bis 16) ausgebildet sind, die über Anschlußkabel mit einer elektrischen Energiequelle verbindbar sind und die zum Verbinden von am Motor (4) ausgebildeten Kontaktfahnen oder Kontaktstiften (18) dienen, wobei die Kontaktstifte (18) an die Endabschnitte (13 bis 16) in Form von Berührungskontakten angeschlossen sind,
**dadurch gekennzeichnet,**
daß die Endabschnitte (13 bis 16) an Leiterbahnen (5 bis 8) ausgebildet sind, daß die Leiterbahnen aus Blech ausgestanzt sind, daß die Endabschnitte (13 bis 16) derart elastisch verformbar ausgebildet sind, daß die Kontaktstifte (18) des Motors (4) bei dessen Verschiebung in Längsrichtung der Motorachse an die Endabschnitte (13 bis 16) federelastisch andrückbar sind und daß zur Bildung eines Schalters an die Leiterbahnen (5, 6) einander benachbarte Kontaktfahnen (23, 24) angeformt sind, von denen eine der Kontaktfahnen (23) unter elastischer Verformung mit Hilfe eines bewegbaren Betätigungselements (27) an die andere Kontaktfahne (24) andrückbar ist.

2. Träger nach Anspruch 1,
**dadurch gekennzeichnet,**
daß die Endabschnitte (13 bis 16) der Leiterbahnen (5 bis 8) U-förmig abgebogen sind.

3. Träger nach einem der Ansprüche 1 oder 2,
**dadurch gekennzeichnet,**
daß die elastisch verformbaren Endabschnitte (13 bis 16) in eine schlitzförmige Öffnung (17) in der Platine (2) ragen und die Kontaktfahnen oder Kontaktstifte (18) der Motoranschlüsse auf der den Leiterbahnen (5 bis 8) abgekehrten Seite der Platine (2) angeordnet sind.

4. Träger nach einem der vorhergehenden Ansprüche,
**dadurch gekennzeichnet,**
daß die Leiterbahnen (5 bis 8) als einteiliges Blechelement durch formschlüssige Mittel mit der Platine (2) verbindbar sind und die Platine (2) Öffnungen (34) oder Aussparungen aufweist, durch die hindurch das Blechelement nach seiner Montage mittels eines Trennwerkzeugs in die einzelnen, voneinander getrennte Strompfade bildenden Leiterbahnen (5 bis 8) zerteilbar ist.

5. Träger nach Anspruch 1,
**dadurch gekennzeichnet,**
daß die Leiterbahnen (5 bis 8) elastisch verformbare Abschnitte (12) aufweisen, die jeweils zwischen paarweise einander zugekehrte Haken (10, 11) einrastbar sind.

6. Träger nach einem der vorhergehenden Ansprüche,
**dadurch gekennzeichnet,**
daß auf der Platine (2) Vorsprünge (25, 26) vorgesehen sind, zwischen denen die Leiterbahnen (5 bis (8) verlaufen.

7. Träger nach Anspruch 1,
**dadurch gekennzeichnet,**
daß die Kontaktfahnen (23, 24) aus der Grundebene des Blech elements durch rechtwinkliges Abkanten derart herausgebogen sind, daß sie hochkant auf der Grundebene stehen und sich parallel zu dieser erstrecken.

8. Träger nach einem der vorhergehenden Ansprüche,
**dadurch gekennzeichnet,**
daß die Platine (2) an einer Seite mehrere, hinterschnittene Schlitze (9) aufweist, in die das Anschlußkabel in Form mäanderförmiger Windungen einknöpfbar ist.

9. Träger nach Anspruch 8,
**dadurch gekennzeichnet,**
daß die Platine (2) an die Schlitze (9) angrenzende Wandelemente aufweist, die die mänderförmigen Windungen des Anschlußkabels teilweise umhüllen.

## Claims

1. A supporting structure for an electric motor of a kitchen appliance, in particular a citrus juicer, including a panel fabricated from an insulating material and having a mount for securing the motor (4), on which mount end portions (13 to 16) are provided which are adapted to be connected to a source of electricity through a connecting cable and serve the function of connecting contact lugs or contact pins (18) provided on the motor (4), with the contact pins (18) being connected to the end portions (13 to 16) by making physical contact therewith,
**characterized in that** the end portions (13 to 16) are provided on conductive strips (5 to 8), that the conductive strips are blanked from sheet metal, that the end portions (13 to 16) are elastically deformable such that the contact pins (18) of the motor (4), on displacement of the motor in the longitudinal direction of the motor axis, are adapted to be resiliently urged into engagement with the end portions (13 to 16), and that for the formation of a switch adjacent contact lugs (23, 24) are formed on the conductive strips (5, 6), one (23) of the contact lugs being adapted to be urged into engagement with the other contact lug (24) by means of a movable actuating member (27) deforming it elastically in the process.

2. The supporting structure as claimed in claim 1,
**characterized in that** the end portions (13 to 16) of the conductive strips (5 to 8) are bent in U-shape.

3. The supporting structure as claimed in any one of the claims 1 or 2,
**characterized in that** the elastically deformable end portions (13 to 16) extend into a slotted opening (17) in the panel (2), and that the contact lugs or contact pins (18) of the motor terminals are arranged on the side of the panel (2) remote from the conductive strips (5 to 8).

4. The supporting structure as claimed in any one of the preceding claims,
**characterized in that** the conductive strips (5 to 8), in forming a single-piece sheet-metal element, are adapted to be connected to the panel (2) by positive-engagement means, and that the panel (2) includes openings (34) or cutouts through which a parting tool may reach to sever the sheet-metal element, following its assembly, into the individual conductive strips (5 to 8) forming separate current paths.

5. The supporting structure as claimed in claim 1,
**characterized in that** the conductive strips (5 to 8) include elastically deformable portions (12) which are each lockingly engageable between respective hooks (10, 11) facing each other in pairs.

6. The supporting structure as claimed in any one of the preceding claims,
**characterized in that** projections (25, 26) between which the conductive strips (5 to 8) extend are provided on the panel (2).

7. The supporting structure as claimed in claim 1,
**characterized in that** the contact lugs (23, 24) are formed out of the plane of the sheet-metal element by bending them at right angles in such a fashion that they are upended on the plane and extend parallel thereto.

8. The supporting structure as claimed in any one of the preceding claims,
**characterized in that** one end of the panel (2) is provided with several undercut slots (9) into which the connecting cable is engageable in the form of meandering windings.

9. The supporting structure as claimed in claim 8,
**characterized in that** the panel (2) includes wall elements adjoining the slots (9) and partially embracing the meandering windings of the connecting cable.

## Revendications

1. Support pour le moteur électrique d'une machine de cuisine, en particulier presse-citrons, qui comporte une platine en matériau isolant avec une réception pour fixer le moteur (4), sur laquelle sont fixés des tronçons d'extrémité (13 à 16) qui peuvent être reliés via des câbles de raccordement à une source d'énergie électrique et qui servent à raccorder des pattes ou des tiges de contact (18) réalisées sur le moteur (4), les tiges de contact (18) étant raccordées aux tronçons d'extrémité (13 à 16) sous la forme de contacts fonctionnant par toucher,
caractérisé en ce que les tronçons d'extrémité (13 à 16) sont réalisés sur des pistes conductrices (5 à 8), en ce que les pistes conductrices sont estampées en tôle, en ce que les tronçons d'extrémité (13 à 16) sont réalisés de manière à pouvoir être déformés élastiquement de telle manière que les tiges de contact (18) du moteur (4) peuvent être repoussées élastiquement contre les tronçons d'extrémité (13 à 16), lors de son déplacement en direction longitudinale de l'axe du moteur, et en ce que pour former un commutateur, des pattes de contact (23, 24) voisines l'une de l'autre sont formées sur les pistes conductrices (5, 6), parmi lesquelles l'une des pattes de contact (23) peut être repoussée contre l'autre patte de contact (24) sous déformation élastique à l'aide d'un élément d'actionnement mobile (27).

2. Support selon la revendication 1, caractérisé en ce que les tronçons d'extrémité (13 à 16) des pistes conductrices (5 à 8) sont recourbés en forme de U.

3. Support selon l'une ou l'autre des revendications 1 et 2, caractérisé en ce que les tronçons d'extrémités élastiquement déformables (13 à 16) pénètrent dans une ouverture (17) en forme de fente dans la platine (2), et en ce que les pattes de contact ou tiges de contact (18) des bornes du moteur sont agencées sur le côté de la platine (2) détourné des pistes conductrices (5 à 8).

4. Support selon l'une des revendications précédentes, caractérisé en ce que les pistes conductrices (5 à 8), sous la forme d'un élément de tôle d'une seule pièce, peuvent être reliées à la platine (2) par des moyens à coopération de formes, et en ce que la platine (2) comporte des ouvertures (34) ou des évidements, à travers lesquelles l'élément en tôle peut être subdivisé après son montage au moyen d'un outil de séparation pour former les pistes conductrices (5 à 8) individuelles qui forment les trajets de courant séparés les uns des autres.

5. Support selon la revendication 1, caractérisé en ce que les pistes conductrices (5 à 8) comportent des tronçons (12) élastiquement déformables qui peuvent être encliquetés respectivement entre des crochets (10, 11) dirigés l'un vers l'autre par paires.

6. Support selon l'une des revendications précédentes, caractérisé en ce que des saillies (25, 26) sont prévues sur la platine (2), entre lesquelles s'étendent les pistes conductrices (5 à 8).

7. Support selon la revendication 1, caractérisé en ce que les pattes de contact (23, 24) sont recourbées hors du plan de base de l'élément en tôle par torsion à angle droit, de telle manière qu'elles reposent de chant sur le plan de base et s'étendent parallèlement à celui-ci.

8. Support selon l'une des revendications précédentes, caractérisé en ce que la platine (2) comporte sur un côté plusieurs fentes (9) en contre-dépouille, dans lesquelles le câble de raccordement peut être boutonné sous la forme d'ondulations en forme de serpentins.

9. Support selon la revendication 8, caractérisé en ce que la platine (2) comporte des éléments de paroi qui jouxtent les fentes (9) et qui entourent en partie les ondulations en forme de serpentins du câble de raccordement.
